Europäisches Patentamt

**European Patent Office**

**Office européen des brevets**

(11) Numéro de publication: **0 230 336 B1**

# FASCICULE DE BREVET EUROPEEN

(45) Date de publication de fascicule du brevet:
**10.04.91**

(51) Int. Cl.5: **H01L 33/00**

(21) Numéro de dépôt: **87200070.8**

(22) Date de dépôt: **19.01.87**

(54) Dispositif opto-électronique pour montage en surface.

(30) Priorité: **24.01.86 FR 8601028**

(43) Date de publication de la demande:
**29.07.87 Bulletin 87/31**

(45) Mention de la délivrance du brevet:
**10.04.91 Bulletin 91/15**

(84) Etats contractants désignés:
**DE FR GB IT NL**

(56) Documents cités:
**EP-A- 0 143 040**
**WO-A-82/04500**
**GB-A- 2 122 418**
**US-A- 4 301 461**

**PATENTS ABSTRACTS OF JAPAN, vol. 8, no. 78 (E-237)[1515], 10 avril 1984; & JP-A-58 225 673**

**30TH ELECTRONIC COMPONENTS CONFERENCE, San Francisco, CA, US, 28 - 30 avril 1980, pages 279-282, IEEE, New York, US; B.H. JOHNSON et al.: "Connectorized optical link package incorporating a microlens"**

(73) Titulaire: **PHILIPS COMPOSANTS**
**117, quai du Président Roosevelt**
**F-92130 Issy les Moulineaux(FR)FR**

Titulaire: **N.V. Philips' Gloeilampenfabrieken**
**Groenewoudseweg 1**
**NL-5621 BA Eindhoven(NL)DE GB IT NL**

(72) Inventeur: **Thillays, Jacques Société Civile S.P.I.D.**
**209, rue de l'Université**
**F-75007 Paris(FR)**

(74) Mandataire: **Jacquard, Philippe et al**
**Société Civile S.P.I.D. 156, Boulevard Haussmann**
**F-75008 Paris(FR)**

Rank Xerox (UK) Business Services

APPLIED OPTICS, vol. 24, no. 3, 1er février 1985, pages 343-348, Optical Society of America, New York, US; P.P. DEIMEL: "Calculations for integral lenses on surface-emitting diodes"

PATENTS ABSTRACTS OF JAPAN, vol. 5, no. 198 (E-87)[870], 16 décembre 1981; & JP-A-56 120 177

PATENTS ABSTRACTS OF JAPAN, vol. 6, no. 32 (E-96)[910], 26 février 1982; & JP-A-56 152 274

# Description

La présente invention a pour objet un dispositif opto-électronique pour montage en surface comportant un substrat isolant présentant une surface supérieure sur laquelle est disposé au moins un élément opto-électronique, et des bandes conductrices disposées sur la face supérieure et en liaison électrique avec des éléments de contact situés sur la surface inférieure du substrat, une première bande conductrice étant en contact électrique avec la face inférieure de l'élément opto-électronique et au moins une deuxième bande conductrice étant reliée par un fil conducteur à la face supérieure de l'élément opto-électronique.

Un tel dispositif est connu du brevet européen EP-B-0083627. Dans celui-ci, l'élément opto-électronique est moulé dans un dôme en résine époxy ce qui assure son étanchéité. Cette technique de moulage ne permet pas d'obtenir une très bonne qualité optique en raison en particulier des problèmes de centrage, de retrait et d'état de surface.

Une technique connue pour associer une optique à un élément opto-électronique est de réaliser une lentille en verre fondu dans une fenêtre du dispositif ce qui assure également l'étanchéité de l'élément opto-électronique. Le résultat est meilleur que précédemment , mais la forme obtenue n'est pas rigoureuse sur le plan optique car elle correspond à la forme d'une goutte et l'état de surface n'est pas non plus de très bonne qualité.

Une autre technique, décrite dans la demande de brevet PCT N° 82/04500 (MOTOROLA), consiste enfin à localiser une microlentille sphérique dans un anneau réalisé sur l'élément opto-électronique, et à enrober l'ensemble dans un polymère transparent assurant l'étanchéité de l'élément opto-électronique. Un tel enrobage a pour effet de dégrader les performances optiques du dispositif pour des raisons déjà exposées, et interdit en outre au dispositif d'être monté en surface.

Patents Abstracts of Japan vol.8 no.78 (E-237)-[1515] 10 Avril 1984 décrit un dispositif electroluminescent comportant une diode electroluminescente montée sur un substrat isolant, une entretoise entourant le diode et supportant une lentille cylindrique, l'espace interieur entre la lentille, l'entretoise et le substrat étant rempli d'une résine transparente.

La présente invention a pour objet un dispositif opto-électronique étanche pour montage en surface qui présente également une haute qualité optique et qui soit facile à réaliser, car comportant un nombre minimal de pièces à assembler.

Le dispositif selon l'invention est dans ce but caractérisé en ce qu'il comporte une entretoise annulaire entourant ledit élément opto-électronique et fixée de manière étanche à la surface supérieure du substrat isolant de manière que son axe soit sensiblement l'axe optique dudit élément opto-électronique, ladite entretoise ayant une hauteur supérieure à l'épaisseur de l'élément opto-électronique et en ce qu'il comporte une lentille sphérique en matériau transparent de diamètre supérieur au diamètre intérieur de l'entretoise annulaire et collée de manière étanche en butée sur celle-ci et espacée de la face supérieure dudit élément opto-électronique par une distance telle que le plan d'émission lumineuse dudit élément opto-électronique soit situé à une distance de la lentille sphérique inférieure ou égale à son tirage.

Selon un mode de réalisation, l'éspace intérieur de ladite entretoise annulaire délimité par le substrat isolant, l'élément opto-électronique et la lentille sphérique est rempli par une colle transparente d'indice donné destinée à assurer ledit collage étanche de la lentille sphérique. Cette colle a également pour effet d'augmenter le tirage de la lentille sphérique.

Selon un mode de réalisation préféré, le dispositif selon l'invention est rendu insensible aux problèmes de dilatation thermique en choisissant pour le substrat isolant, l'entretoise annulaire, et la lentille sphérique des matériaux comportant essentiellement de l'alumine. A titre d'exemple, le substrat isolant est en céramique, l'entretoise annulaire en alumine et la lentille sphérique en saphir ou en rubis.

Selon une variante convenant notamment à des dispositifs bicolores, au moins deux éléments opto-électroniques sont entourés par ladite entretoise annulaire et les faces supérieures des éléments opto-électroniques sont reliées chacune par un fil conducteur à ladite deuxième et à une troisième bande conductrice.

L'invention sera mieux comprise à la lecture de la description qui va suivre donnée à titre d'éxemple non limitatif en liaison avec les dessins qui représentent :

- la figure 1 et 2 respectivement, en coupe verticale et en vue de dessus, un dispositif selon l'invention.

- La figure 3, un mode de réalisation d'un gabarit de montage d'un dispositif opto-électronique selon l'invention

- la figure 4, une vue de dessus d'une variante de l'invention comportant deux éléments opto-électroniques.

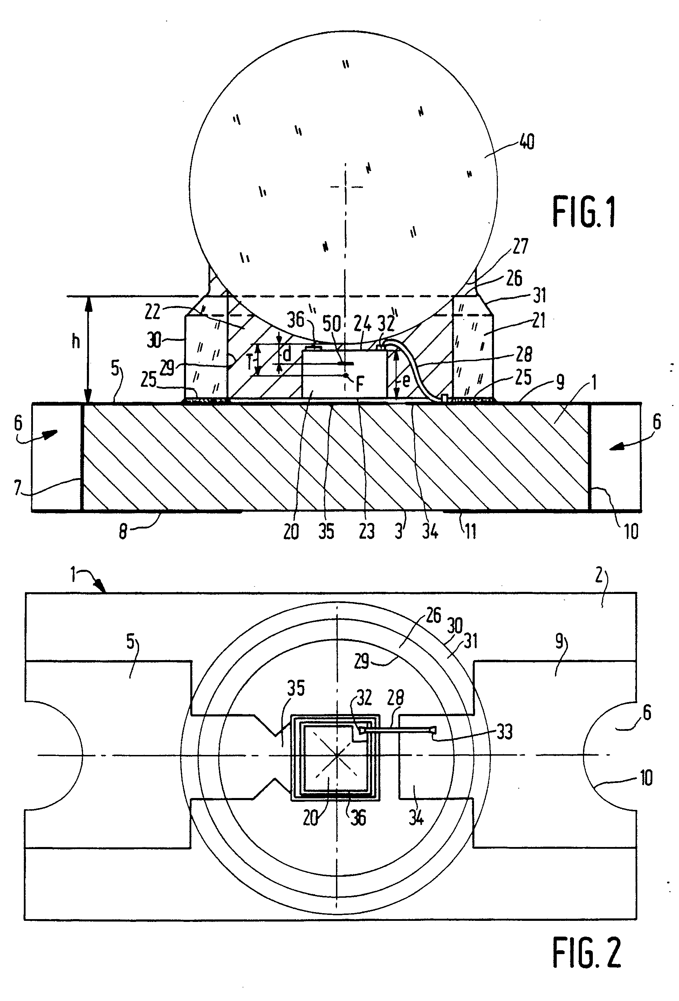

Selon les figures 1 et 2, le dispositif selon l'invention comporte un substrat isolant 1 par exemple en céramique d'épaisseur e dont la face supérieure 2 comporte deux bandes conductrices 5 et 9 avantageusement réalisées par sérigraphie et qui communiquent avec deux bandes conductrices respectivement 8 et 11 de la face inférieure 3 du substrat. Les bandes conductrices 8 et 11 constituent les éléments de contact de la face inférieure 3.

Le substrat isolant est pourvu latéralement et sur chacun de deux côtés opposés d'une ouverture de section semi-circulaire 6. Chaque ouverture 6 est entièrement revêtue d'une couche conductrice 10 qui met en contact électrique d'une part les bandes conductrices 5 et 8 et d'autre part les bandes conductrices 9 et 11.

Dans le cas où le substrat 1 est en céramique, les bandes conductrices 5, 8, 9 et 11 ainsi que la couche conductrice 10 sont facilement réalisables par sérigraphie, en employant par exemple la technologie utilisée pour la fabrication des supports en céramique pour semi-conducteurs, ou bien les condensateurs céramique.

Un élément opto-électronique 20, par exemple un élément électro-luminescent tel qu'une diode électro-luminescente, est soudé par sa face inférieure 23 sur une patte 35 de la couche conductrice 5 de telle sorte qu'une de ses électrodes soit en contact électrique avec cette dernière. Son autre électrode 36 est constituée par une métallisation annulaire 36 de la face supérieure 24 de l'élément 20, présentant une patte 32 de petites dimensions permettant d'y souder une extrémité d'un fil 28 dont l'autre extrémité est soudée en 33 sur une patte 34 de la bande conductrice 9.

Une lentille sphérique 40, par exemple une bille de qualité horlogerie en rubis ou en saphir, est disposée en butée sur une entretoise annulaire 21 dont le diamètre intérieur 29 est à cet effet inférieur au diamètre de la bille. Le diamètre 29 et la hauteur h de l'entretoise annulaire 21 sont choisis de telle manière que le plan lumineux actif 50, à savoir le plan d'émission lumineuse pour une diode électro-luminescente, et qui se situe à l'intérieur de l'élément opto-électronique 20, soit lui-même disposé à une distance d du bord de la lentille 40 inférieure ou égale à son tirage.

La fixation de la lentille sphérique 40 est avantageusement réalisée à l'aide d'une colle 22 transparente d'indice donné qui remplit l'espace intérieur de l'entretoise annulaire 21 délimité par la face supérieure 2 du substrat 1, l'élément 20, et la lentille sphérique 40, tout en débordant légèrement en 27 pour assurer la fixation de la lentille 40. L'entretoise annulaire 21 est elle-même fixée de manière étanche sur le substrat 1 par exemple à l'aide d'une pâte à souder déposée par sérigraphie ce qui permet d'obtenir une épaisseur reproductible.

Lorsque la distance d est égale au tirage T de la lentille 40, le foyer de la lentille 40 pris dans l'axe optique de l'élément 20 est situé dans le plan 50, et le plus près possible de son centre, pour le cas représenté où un seul élément 20 est mis en oeuvre.

Autrement dit, l'axe optique de l'élément 20 passe le plus près possible du centre de la lentille sphérique 40.

Cette position correspond à la directivité maximale du dispositif.

Lorsque la distance d est inférieure au tirage T, le dispositif est moins directif. Il est donc facile d'obtenir un dispositif ayant la directivité souhaitée en jouant sur la hauteur h de l'entretoise annulaire 21 ou l'épaisseur e de l'élément 20.

Si on désigne par N l'indice de la lentille sphérique 40, par R son rayon, et par n l'indice de la colle 22, le tirage T de la lentille à pour valeur :

$$T = \frac{n\,(2 - N)}{N - 2n + nN}\; |R|$$

On rappelle que le tirage T est la distance entre le foyer pris sur l'axe optique et le bord de la lentille.

A titre d'exemple, pour une lentille 40 en rubis ou en saphir (N = 1,768) de diamètre 1 500 microns, on a T = 168 microns avec une colle élastomère d'indice n = 1,4 et T = 194 microns avec une colle photopolymérisable d'indice n = 1,56, alors que si le collage est réalisé de manière à laisser libre l'espace intérieur (n = 1), on a alors T = 109 microns. La présence de la colle 22 dans l'espace intérieur augmente considérablement le tirage de la lentille 40, et donc permet un positionnement plus précis.

On remarquera que l'utilisation d'une colle élastomère évite les contraintes mécaniques, alors que celle d'une colle photopolymérisable n'introduit que des contraintes faibles.

Le dispositif selon l'invention présente de manière remarquable toutes les caractéristiques souhaitées pour un composant monté en surface. La lentille sphérique 40 remplit en particulier une double fonction, d'une part optique comme il l'a été dit, et d'autre part mécanique car elle assure la fermeture et l'étanchéité du dispositif. Le rubis ou le saphir sont particulièrement bien adaptés étant donné que ce sont des matériaux durs.

En outre, si on choisit un substrat 1, une entretoise annulaire 21 et une lentille sphérique 40 en des matériaux comportant essentiellement de l'alumine, par exemple en prenant un substrat 1 en céramique, une entretoise annulaire 21 en alumine et une lentille sphérique 21 en rubis ou en saphir, le dispositif est alors insensible aux écarts de température car ces matériaux ont des coefficients de dilatation thermique quasiment identiques.

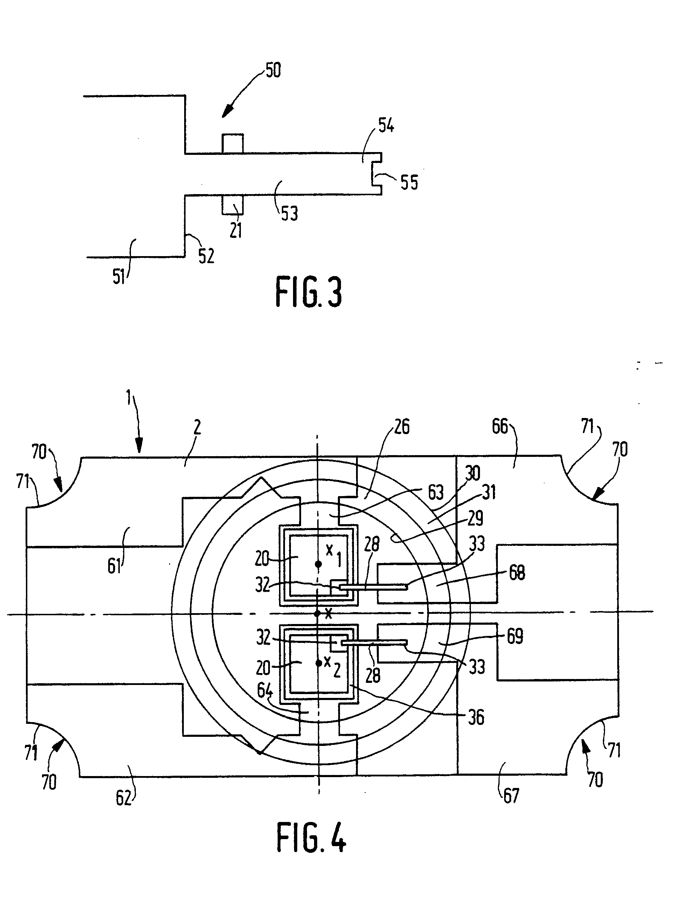

La figure 3 représente un gabarit 50 de montage concentrique d'un élément 20 et d'une entretoise annulaire 21. Il comporte une partie arrière cylindrique se prolongeant vers l'avant par un axe 53 de diamètre plus petit, et est égal à un faible jeu près au diamètre intérieur 29 de l'entretoise annulaire 21. La partie avant 54 de l'axe 53 porte un logement carré 55 centré avec précision sur l'axe 53 et dans lequel vient se loger un élément 20. Il suffit de positionner sous binoculaire le gabarit 50 par rapport à des repères du substrat pour que l'élément 20 et l'entretoise 21 soient à leur tour positionnés avec une très bonne concentricité à l'endroit choisi.

La figure 4 illustre le cas où deux éléments opto-électroniques 20 sont mis en oeuvre à l'intérieur de l'entretoise annulaire 21. Une telle disposition est intéressante notamment dans le cas des voyants bi-ou tri-colores. Dans ce cas chacun des éléments est 20 soudé sur une patte conductrice 63, 64 d'une bande conductrice 61, 62. Chacun comporte un fil conducteur 28 reliant son électrode supérieure 36 à une patte conductrice 68, 69 d'une bande conductrice 66, 67 qui lui est propre. Les bandes conductrices 61, 62, 66 et 67 sont en liaison électrique avec des éléments de contact disposés dans les angles de la face inférieure 3, grâce à quatre couches conductrices 71 revêtant des ouvertures 70 présentant en section une forme de quart de cercle et disposées aux quatre coins du substrat isolant 1.

Chacun des éléments opto-électronique 20 présente un axe optique $X_1$, $X_2$. L'axe optique du dispositif est choisi comme étant l'axe médian des axes $X_1$ et $X_2$. La mise en place des éléments 20 peut s'effectuer à l'aide d'un gabarit tel que 50 présentant deux logements 55.

## Revendications

1. Dispositif opto-électronique pour montage en surface comportant un substrat isolant présentant une surface supérieure sur laquelle est disposé au moins un élément opto-électronique et des bandes conductrices disposées sur la surface supérieure et en liaison électrique avec des éléments de contact situés sur la surface inférieure du substrat, une première bande conductrice étant en contact électrique avec la face inférieure de l'élément opto-électronique et au moins une deuxième bande conductrice étant reliée par un fil conducteur à la face supérieure de l'élément opto-électronique caractérisé en ce qu'il comporte une entretoise annulaire (21) entourant ledit élément opto-électronique (20) et fixée de manière étanche à la surface supérieure (2) du substrat isolant (1) de manière que son axe soit sensiblement l'axe optique dudit élément opto-électronique (20), ladite entretoise ayant une hauteur supérieure à l'épaisseur de l'élément opto-électronique (20) et en ce qu'il comporte une lentille sphérique (40) en matériau transparent de diamètre supérieur au diamètre intérieur de l'entretoise annulaire et collée de manière étanche en butée sur celle-ci et espacée de la face supérieure (24) dudit élément opto-électronique par une distance telle que le plan d'émission lumineuse (50) dudit élément opto-électronique (20) soit situé à une distance de la lentille sphérique (40) inférieure ou égale à la distance (T) de la lentille sphérique à son foyer (F).

2. Dispositif selon la revendication 1 caractérisée en ce que l'espace intérieur de ladite entretoise annulaire (21) délimité par le substrat isolant (1), l'élément opto-électronique (20) et la lentille sphérique (40) est rempli par une colle transparente (22) d'indice donné destinée à assurer ledit collage étanche de la lentille sphérique (40).

3. Dispositif selon une des revendications 1 ou 2 caractérisé en ce que le substrat isolant (1), l'entretoise annulaire (21) et la lentille sphérique (40) sont en des matériaux comportant essentiellement de l'alumine.

4. Dispositif selon la revendication 3 caractérisé en ce que le substrat (1) isolant est en céramique.

5. Dispositif selon une des revendications 3 ou 4 caractérisé en ce que l'entretoise annulaire (21) est en alumine.

6. Dispositif selon une des revendications 3 à 5 caractérisé en ce que la lentille sphérique (40) est en un matériau choisi parmi le saphir et le rubis.

7. Dispositif selon une des revendications précédentes caractérisé en ce qu'il comporte au moins deux éléments opto-électroniques entourés par ladite entretoise annulaire (21) et en ce que les faces supérieures (24) des éléments opto-électroniques sont reliés chacune par un fil conducteur (28) à ladite deuxième (66) à une troisième (67) bande conductrice.

## Claims

1. An optoelectronic device for surface mounting comprising an insulating substrate having an upper surface, on which at least one optoelectronic element is disposed, and conductive strips disposed on the upper surface and in electrical contact with contact members situated on the lower surface of the substrate, a first conductive strip being in electrical contact with the lower surface of the optoelectronic element and at least a second conductive strip being connected through a conductive wire to the upper surface of the optoelectronic element, characterized in that it comprises an annular spacer (21 ) enclosing the said optoelectronic element (20) and fixed in an impermeable manner to the upper surface (2) of the insulating substrate (1) in such a way that its axis substantially equals the optical axis of the said optoelectronic element (20), the said spacer having a height feeding the thickness of the optoelectronic element (20), and in that it comprises a spherical lens (40) of a transparent material having a diameter exceeding the inner diameter of the annular spacer and glued impermeably against the latter and spaced apart from the upper surface (24) of the said optoelectronic element by such a distance that the plane of light emission (50) of the said optoelectronic element (20) is situated at a distance from the spherical lens (40) which is less than or equal to the distance (T) between the spherical lens and its focus (F).

2. A device as claimed in Claim 1, characterized in that the inner space of the said annular spacer (21) bounded by insulating substrate (1), the optoelectronic element (20) and the spherical lens (40) is filled a transparent glue (22) having a given refractive index intended to ensure the said impermeable gluing of the spherical lens (40).

3. A device as claimed in any one of Claims 1 or 2, characterized in that the insulating substrate (1), the annular spacer (21) and the spherical lens (40) are made of materials mainly comprising alumina.

4. A device as claimed in Claim 3, characterized in that the insulating substrate (1) is made of ceramic material.

5. A device as claimed in any one of Claims 3 or 4, characterized in that the annular spacer (21) is made of alumina.

6. A device as claimed in any one of Claims 3 to 5, characterized in that the spherical lens (40) is made of a material chosen from sapphire and ruby.

7. A device as claimed in any one of the preceding Claims, characterized in that it comprises at least two optoelectronic elements enclosed by the said annular spacer (21), and in that the upper surfaces (24) of the optoelectronic elements are each connected through a conductive wire (28) to the said second (66) or to a third (67) conductive strip.

## Ansprüche

1. Optoelektronische Anordnung zur Oberflächenmontage mit einem isolierenden Träger mit einer oberen Fläche, auf der wenigstens ein optoelektronisches Element vorgesehen ist, sowie Leiterstreifen, die mit Kontaktelementen auf der unteren Fläche des Trägers in elektrischem Kontakt stehen, wobei ein erster Leiterstreifen mit der unteren Fläche des optoelektrischen Elementes in elektrischer Verbindung steht und wenigstens ein zweiter Leiterstreifen über einen leitenden Draht mit der oberen Fläche des optoelektronischen Elementes verbunden ist, dadurch gekennzeichnet, daß die Anordnung ein das genannte optoelektronische Element (20) einschließendes, ringsförmiges Distanzteil (21) aufweist, das auf undurchlässige Weise an der oberen Fläche (2) des isolierenden Trägers (1) befestigt ist, derart, daß seine Achse im wesentlichen die optische Achse des genannten optoelektronischen Elementes (20) ist wobei das genannte Distanzteil eine Höhe aufweist, die größer ist als die Dicke des optoelektronischen Elementes (20), und daß sie eine sphärische Linse (40) aus einem transparenten Werkstoff aufweist mit einem Durchmesser, der größer ist als der Innendurchmesser des ringförmigen Distanzteils, wobei die Linse auf undurchlässige Weise mit dem letzteren verklebt ist und in einem derartigen Abstand von der oberen Fläche (24) des genannten optoelektronischen Elementes liegt, daß die Lichtaustrittsebene (50) des genannten optoelektronischen Elementes (20) in einem Abstand von der sphärischen Linse (40) liegt, der kleiner ist als der Abstand (T) der sphärischen Linse von ihrem Fokus (F).

2. Anordnung nach Anspruch 1, dadurch gekennzeichnet, daß der durch den isolierenden Träger (1), das optoelektronische Element (20) und die sphärische Linse (40) begrenzte innere Raum des genannten ringförmigen Distanzteils (21) mit einem transparenten Klebstoff (22) mit einer bestimmten Brechzahl gefüllt ist, dies zur Gewährleistung einer undurchlässigen Verklebung der sphärischen Linse (40).

3. Anordnung nach einem der Ansprüche 1 oder 2, dadurch gekennzeichnet, daß der isolierende Träger (1), das ringförmige Distanzteil (21) und die sphärische Linse (40) aus Werkstoffen hergestellt sind, die hauptsächlich Aluminiumoxid aufweisen.

4. Anordnung nach Anspruch 3, dadurch gekennzeichnet, daß der isolierende Träger (1) aus Keramik besteht.

5. Anordnung nach einem der Ansprüche 3 oder 4, dadurch gekennzeichnet, daß das ringförmige Distanzteil (21) aus Aluminiumoxid besteht.

6. Anordnung nach einem der Ansprüche 3 bis 5, dadurch gekennzeichnet, daß die sphärische Linse (40) aus einem Werkstoff besteht, der aus Saphir und Rubin gewählt worden ist.

7. Anordnung nach einem der vorstehenden Ansprüche, dadurch gekennzeichnet, daß sie wenigstens zwei optoelektronische Elemente aufweist, die durch das genannte ringförmige Distanzteil (21) umgeben sind, und daß jede der oberen Flächen (24) der optoelektronischen Elemente mittels je eines leitenden Drahtes (28) mit dem genannten zweiten (66) und einem dritten Leiterstreifen (67) verbunden sind.

FIG.1

FIG. 2

FIG. 3

FIG. 4